# EUROPÄISCHE PATENTSCHRIFT

(11) **EP 3 166 744 B1**
(45) Veröffentlichungstag und Bekanntmachung des Hinweises auf die Patenterteilung: **12.09.2018**
(21) Anmeldenummer: 15749974.0
(22) Anmeldetag: 02.07.2015
(51) Int. Cl.: B23K 20/00, B23K 20/10, H01L 21/67, H01L 23/00, H01L 41/09, B23K 101/42

(54) **VORRICHTUNG ZUR HERSTELLUNG EINER BONDVORRICHTUNG**
DEVICE FOR ESTABLISHING A BONDING CONNECTION
DISPOSITIF DE FABRICATION D'UN ASSEMBLAGE

(30) Priorität: 09.07.2014 DE 102014109630
(43) Veröffentlichungstag der Anmeldung: 17.05.2017
(73) Patentinhaber: Hesse GmbH, 33104 Paderborn (DE)
(72) Erfinder: HUNSTIG, Matthias, 33098 Paderborn (DE); BRÖKELMANN, Michael, 33129 Delbrück (DE)
(74) Vertreter: Wickord, Wiro
(86) Internationale Anmeldenummer: PCT/DE2015/100277
(87) Internationale Veröffentlichungsnummer: WO 2016/004919

(56) Entgegenhaltungen:
- DE-A1-102009 003 312
- US-A1- 2009 268 326
- US-A1- 2013 335 487

## Beschreibung

Die Erfindung betrifft eine Vorrichtung zum Herstellen einer Bondverbindung nach dem Oberbegriff des Patentanspruchs 1 (siehe z.B. DE10 2009 003 312 A1).

Beschrieben ist ferner einen Transducer mit einem Transducerkörper, mit einem an dem Transducerkörper festgelegten Piezoaktor und mit an dem Piezoaktor vorgesehenen Elektroden, wobei der Transducerkörper einen Befestigungsabschnitt zum Festlegen des Transducers an einer Aufnahme einer Werkzeugmaschine und eine Werkzeugaufnahme für ein an den Transducer ansetzbares Werkzeug aufweist.

Klassische Bondvorrichtungen sehen üblicherweise vor, den Transducer und ein an dem Transducer festgelegtes Bondwerkzeug unter einem 90°-Winkel zueinander zu positionieren. Während das Bondwerkzeug sich parallel zu einer Rotationsachse eines den Transducer tragenden Bondkopfs erstreckt, ist der Transducer bezogen auf eine Haupterstreckungsrichtung beziehungsweise Längsrichtung desselben quer zu der Rotationsachse des Bondkopfs vorgesehen. Dieser Aufbau der Bondvorrichtung hat sich grundsätzlich bewährt und ist in der Praxis seit vielen Jahren weit verbreitet. Jedoch ist die Dynamik beim Positionieren beziehungsweise Verfahren des Bondkopfs aufgrund der Orientierung des Transducers begrenzt. Man ist daher bestrebt, durch eine geeignete Ausgestaltung des Transducers die dynamischen Eigenschaften der Bondvorrichtung zu verbessern. Insbesondere gilt es, die Positioniergeschwindigkeit für den Bondkopf zu erhöhen beziehungsweise die Positioniergenauigkeit zu verbessern. Es können dann in gleicher Zeit mehr Bondverbindungen hergestellt werden. Somit verbessert sich die Wirtschaftlichkeit der Bondvorrichtung. Ferner ist man bestrebt, durch eine Reduzierung des Gewichts des Bondkopfs beziehungsweise des daran gehaltenen Transducers den Aufsetzimpuls beim Aufsetzen der Werkzeugspitze auf den Bonddraht zu reduzieren und insofern eine Beschädigung des Bonddrahts oder des Substrats zu vermeiden.

Aus der DE 10 2009 003 312 A1 ist bekannt, einen Transducer so an einer Bondvorrichtung zu befestigen, dass sich die Rotationsachse des Bondkopfs parallel zu der Längsrichtung des Transducers beziehungsweise einer Erstreckungsrichtung desselben in Richtung einer Achse eines minimalen Massenträgheitsmoments orientiert. Es gelingt hierdurch, die Dynamik der Bondvorrichtung zu verbessern. Der Bondkopf mit dem daran gehaltenen Ultraschall-Transducer kann entsprechend schnell und exakt positioniert werden. Das Bondwerkzeug erstreckt sich hierbei in die Längsrichtung des Transducers. Als Teil des Transducers ist eine Mehrzahl von Piezoaktoren vorgesehen, welche um 180° phasenverschoben so angeregt werden, dass an dem Transducer und dem hiermit verbundenen Bondwerkzeug eine Biegeschwingung als Ultraschallschwingung angeregt wird. Infolge der Ultraschallschwingung kann ein Bonddraht, welcher an einer Spitze des Bondwerkzeugs positioniert und gegen ein Substrat gedrückt wird, mit dem Substrat elektrisch leitend verbunden werden. Makroskopisch betrachtet führt die Spitze des Bondwerkzeugs hierbei eine Längsschwingung in die Drahtrichtung aus. In Bezug auf den Piezoaktor legt die Druckschrift zwei grundsätzlich unterschiedliche Konzepte offen. Zum einen werden zwei zueinander beabstandete Piezoaktoren verwendet. Die Piezoaktoren werden phasenversetzt so angeregt, dass sich ein erster Aktor in eine Längsrichtung desselben ausdehnt, während ein zweiter Aktor in seine Längsrichtung komprimiert wird. Stirnseitig sind die zwei Piezoaktoren so miteinander verbunden, dass sich an dem Transducer infolge der periodisch ausgeführten Bewegung der Piezoaktoren die geforderte Ultraschallschwingung ausbildet. Zum anderen ist offenbart, dass scheibenförmige Piezoaktoren an gegenüberliegenden Seiten eines Trägerkörpers appliziert und phasenversetzt angeregt werden. Während ein Aktor sich ausdehnt, wird der andere Aktor auf der gegenüberliegenden Seite gestaucht. In der Folge wird der Trägerkörper und mit ihm der Transducer und das darin gehaltene Bondwerkzeug zu der Ultraschallschwingung angeregt. Gemein ist beiden Ausführungsformen, dass zur Erzeugung der Ultraschallschwingung eine Längsausdehnung beziehungsweise Stauchung der Piezoaktoren beziehungsweise der hierin vorgesehenen Piezokeramiken verwendet wird. Ein zur Anregung der Piezoaktoren genutztes elektrisches Feld ist parallel zu einer Polarisationsrichtung der Piezokeramiken orientiert. Die zur Anregung der Ultraschallschwingung genutzten Aktorbewegungen liegen dann parallel zum elektrischen Feld oder quer dazu. Man spricht insofern davon, dass die zur Anregung der Ultraschallschwingung vorgesehenen Piezoaktoren den 31-Effekt oder den 33-Effekt nutzen.

Aus der US 2013/335487 A1 ist ein Piezoscheraktor bekannt, welcher quasi-statisch betrieben wird und beispielsweise in Druckern zur Anwendung kommt. Mittels des Piezoaktors wird beispielsweise Tinte in Tintenstrahldruckern auf ein Druckmedium aufgetragen.

Aus der US 2009/268326 A1 ist bekannt, einen Piezoscheraktor zur Feinpositionierung zu verwenden.

Aufgabe der vorliegenden Erfindung ist es, eine Bondvorrichtung mit einem Bondkopf und einen daran gehaltenen Ultraschall-Transducer derart weiterzubilden, dass sich bei einer Beibehaltung der guten dynamischen Eigenschaften neue konstruktive Gestaltungsmöglichkeiten insbesondere in Bezug auf den Aufbau des Transducers und die Anordnung des Piezoaktors ergeben. Ferner gilt es, das Gewicht des Transducers weiter zu reduzieren.

Zur Lösung der Aufgabe weist die Erfindung die Merkmale des Patentanspruchs 1 auf.

Der besondere Vorteil der Erfindung besteht darin, dass infolge der Anregung einer Scherschwingung in dem Piezoaktor neue Möglichkeiten zur Integration desselben in den Transducer geschaffen werden. Das Aktorprinzip stellt eine Abkehr vom bisher bekannten dar. Grundsätzlich gilt, dass bei Verwendung eines rechtshändigen, kartesischen Koordinationsystems die Polarisation der Piezokeramik in 3-Richtung erfolgt. Vorliegend wird das elektrische Feld senkrecht hierzu in 1-Richtung angelegt. Durch die Scherbewegung wird dann eine Ultraschallschwingung senkrecht zu der 2-Richtung in der Scherebene angeregt. Der Piezoaktor liegt dabei in einem Knoten der Ultraschallschwingung. Demgegenüber ist bei resonant, das heißt in einer ihrer Eigenmoden betriebenen Ultraschalltransducern bisher stets das elektrische Feld in Richtung der Polarisation angelegt und es wird entweder die Längenänderung in Feldrichtung oder senkrecht hierzu zur Anregung der Ultraschallschwingung verwendet.

Infolge der Verwendung der Scherbewegung in der Scherebene kann der erfindungsgemäße Transducer mit einem einzigen Piezoaktor betrieben werden. Das Vorsehen von zwei gegenphasig angesteuerten Piezoaktoren ist nicht erforderlich. Der Transducer kann hierdurch in eine Längsrichtung desselben sehr schlank ausgeführt werden. Es verbessert sich insofern die Dynamik der Bondvorrichtung weiter und der Transducer kann kostengünstig hergestellt werden. Weiter vereinfacht sich die elektrische Ansteuerung des Transducers beim Vorsehen eines einzigen Piezoaktors. Zudem reduziert sich der Bauraumbedarf mit der Folge, dass das Positionieren des Bondkopfs im Arbeitsraum der Bondvorrichtung vereinfacht wird. Freiheitsgrade bieten sich ferner in Bezug auf die Anordnung der Elektroden. Hier können die Elektroden nunmehr um 90° versetzt zur Polarisationsrichtung der Piezokeramik vorgesehen sein. Entsprechend kann sich die Zugänglichkeit der Elektroden verbessern. Des Weiteren kann der Piezoaktor vorgespannt realisiert sein. Es erhöht sich hierdurch die Robustheit der Anordnung und der Piezoaktor kann mit höheren Schwingamplituden betrieben werden als ein nicht vorgespannter Piezoaktor.

Der Piezoaktor kann formschlüssig, kraftschlüssig und/oder stoffschlüssig mit der Werkzeugaufnahme beziehungsweise dem Befestigungsabschnitt verbunden sein. Abhängig von der Applikation bestehen insofern verschiedene Möglichkeiten zur Integration des Piezoaktors in den Transducer. Beispielsweise kann der Piezoaktor mit der Werkzeugaufnahme beziehungsweise dem Befestigungsabschnitt verklebt sein. Es ergibt sich hierdurch eine flächige Verbindung und die Möglichkeit, die Scherbewegung des Piezoaktors so auf die angrenzenden Komponenten zu übertragen, dass der Transducer sowie ein hieran gehaltenes Bondwerkzeug zu einer Ultraschallschwingung in der Scherebene angeregt werden. Das Vorsehen der Verklebung beansprucht sehr wenig Bauraum und begünstigt die Miniaturisierung des Transducers.

Nach einer Weiterbildung der Erfindung kann der Piezoaktor gegen die Werkzeugaufnahme beziehungsweise den Befestigungsabschnitt verklemmt vorgesehen sein. Eine Verklemmung kann beispielsweise im Zuge der Montage realisiert werden, indem die unterschiedlichen thermischen Ausdehnungskoeffizienten der beteiligten Materialien genutzt werden. Beispielsweise kann zur Klemmung des Piezoaktors ein Klemmmodul vorgesehen werden. Insbesondere kann das Klemmmodul mechanisch verstellbar realisiert werden. Beispielsweise können Keile, welche gegeneinander verschiebbar vorgesehen sind, als Teil des Klemmmoduls realisiert werden. Beispielsweise können relativ zueinander bewegliche Klemmbacken und ein Betätigungsmittel für die Klemmbacken, beispielsweise ein Exzenter, vorgesehen werden zur Realisierung der Klemmung des Piezoaktors. Beispielsweise können Schrauben zum Klemmen beziehungsweise Festlegen des Piezoaktors verwendet werden.

Nach einer Weiterbildung der Erfindung sind an dem Piezoaktor auf zwei gegenüberliegenden Seiten ebene Anlageflächen ausgebildet. Mit den ebenen Anlageflächen wird der Piezoaktor an korrespondierend gestaltete Anschlussflächen der Werkzeugaufnahme, des Befestigungsabschnitts oder des Klemmmoduls angelegt. Die Geometrie der Anlageflächen an dem Piezoaktor und der korrespondierend gestalteten Anschlussflächen an der Werkzeugaufnahme, dem Befestigungsabschnitt beziehungsweise dem Klemmmodul sind so gestaltet, dass die verwindungssteife Anbindung realisiert ist. Vorteilhaft ergibt sich durch das Vorsehen geeigneter Anlageflächen eine robuste Gestaltung des Transducers. Die in der Scherebene ausgeführte Schwingung wird zuverlässig so auf die angrenzenden Komponenten übertragen, dass sich die Ultraschallschwingung in dem Transducer und dem hieran festgelegten Bondwerkzeug überträgt und ein im Bereich einer Werkzeugspitze geführter und gegen ein Substrat gedrückter Bonddraht mit dem Substrat verbondet wird. Die Anlageflächen können ebenso wie die Anschlussflächen geometrisch einfach gestaltet sein. Die einfache Gestaltung der Flächen begünstigt die Herstellbarkeit.

Nach einer Weiterbildung der Erfindung ist als Teil des Transducers ein Transducerkörper vorgesehen. An dem Transducerkörper ist eine Ausnehmung vorgesehen, in welche der Piezoaktor und optional das Klemmmodul eingesetzt werden. Insbesondere sind die Werkzeugaufnahme und der Befestigungsabschnitt als Teil des Transducerkörpers realisiert. Vorteilhaft vereinfacht sich die Integration des Piezoaktors in den Transducer durch das Vorsehen der Ausnehmung. Es ergibt sich ein robuster, dauerfester Aufbau für den Transducer. Der Piezoaktor wird hierbei quasi zu einem integralen Bestandteil des Transducerkörpers. Grenzflächen der Ausnehmung können beispielsweise als zu den ebenen Anlageflächen des Piezoaktors korrespondierend gestaltete Anschlussflächen der Werkzeugaufnahme, des Befestigungsabschnitts oder des Klemmmoduls dienen. Zudem reduziert sich die Teilezahl durch das Vorsehen des Transducerkörpers und die Integration der Werkzeugaufnahme und des Befestigungsabschnitts. Die Werkzeugaufnahme und der Befestigungsabschnitt haben eine definierte Relativposition zueinander und zu dem in die Ausnehmung eingesetzten Piezoaktor. Die Ultraschallschwingung, welche sich beispielsweise als eine Biegeschwingung an dem Transducer und dem hieran gehaltenen Bondwerkzeug ausbildet, ist entsprechend exakt.

In Bezug auf den Transducer sind die Elektroden derart an dem Piezoaktor positioniert, dass der Piezoaktor quer zu einer Polarisationsrichtung desselben in eine Feldrichtung mittels eines elektrischen Felds anregbar ist und dass der Piezoaktor infolge der Anregung eine Scherbewegung als eine Ultraschalleigenschwingung in einer durch die Polarisationsrichtung und die Feldrichtung gebildeten Scherebene ausführt. Beispielsweise führt dies dazu, dass resultierend der Transducer die Ultraschalleigenschwingung als Biegeschwingung ausführt. Beispielsweise erfolgt die Ultraschallschwingung um eine zu der Scherebene senkrecht orientierte Drehachse.

Der besondere Vorteil der Erfindung besteht darin, dass der erfindungsgemäße Piezoaktor klein und kompakt baut und demzufolge ein geringes Gewicht aufweist. Beim Anbau des Transducers an einen Bondkopf oder eine Aufnahme einer anderen Werkzeugmaschine werden insofern gute dynamische Eigenschaften und ein geringes Gewicht erreicht. Der Transducer kann beispielsweise in Bondvorrichtungen verwendet werden. Beispielsweise kann der Transducer beim ultraschallunterstützten Löten oder beim ultraschallunterstützten Reinigen von Bauteilen angewendet werden.

Aus den weiteren Unteransprüchen und der nachfolgenden Beschreibung sind weitere Vorteile, Merkmale und Einzelheiten der Erfindung zu entnehmen. Dort erwähnte Merkmale können jeweils einzeln für sich oder auch in beliebiger Kombination erfindungswesentlich sein. Erfindungsgemäß beschriebene Merkmale und Details der Vorrichtung gelten selbstverständlich auch im Zusammenhang mit dem erfindungsgemäßen Transducer und umgekehrt. So kann auf die Offenbarung zu den einzelnen Erfindungsaspekten stets wechselseitig Bezug genommen werden. Die Zeichnungen dienen lediglich beispielhaft der Klarstellung der Erfindung und haben keinen einschränkenden Charakter.

Ausführungsbeispiele der Erfindung werden nachfolgend anhand von Zeichnungen näher erläutert.

Es zeigen:
- Fig. 1: eine perspektivische Ansicht eines erfindungsgemäßen Transducers mit einem Piezoaktor in einer ersten Ausführungsform,
- Fig. 2: eine Schwingungsdarstellung für den Transducer nach Fig. 1 in einem angeregten Zustand,
- Fig. 3: eine vergrößerte Darstellung des Piezoaktors des Transducers nach Fig. 1 in dem angeregten Zustand nach Fig. 2,
- Fig. 4: eine perspektivische Ansicht des erfindungsgemäßen Transducers in einer zweiten Ausführungsform,
- Fig. 5: eine perspektivische Ansicht des erfindungsgemäßen Transducers in einer dritten Ausführungsform,
- Fig. 6: eine perspektivische Ansicht des erfindungsgemäßen Transducers in einer vierten Ausführungsform,
- Fig. 7: eine Schwingungsdarstellung für den Transducer nach Fig. 6 in einem angeregten Zustand und
- Fig. 8: eine vergrößerte Darstellung des Piezoaktors des Transducers nach Fig. 6 in dem angeregten Zustand nach Fig. 7.

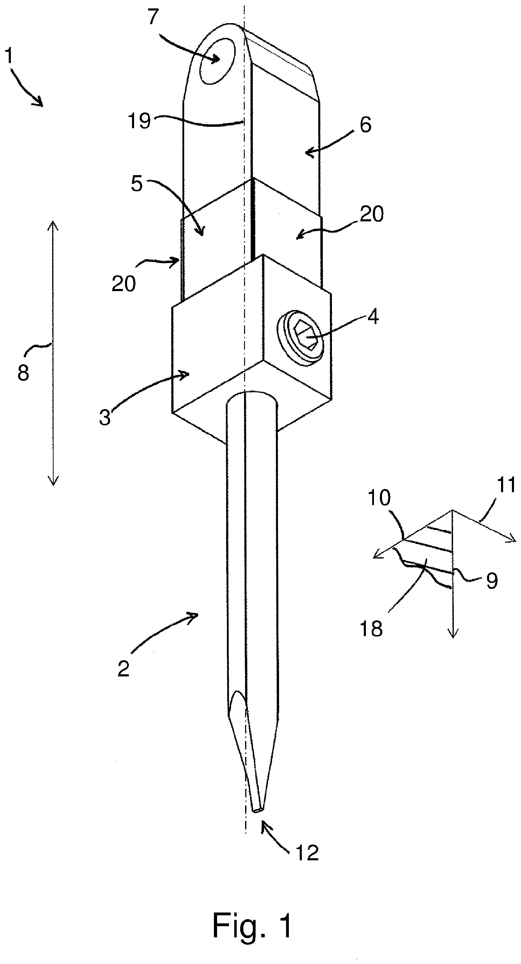

Ein erfindungsgemäßer Transducer 1 nach Fig. 1 wird an einem Bondkopf einer Bondvorrichtung festgelegt. Der Bondkopf wird über verschiedene Aktoren der Bondvorrichtung in Bezug zu einem Substrat positioniert. Mit dem erfindungsgemäßen Transducer 1 wird dann ein Bonddraht mit dem Substrat verbondet. Hierzu ist an einer Werkzeugaufnahme 3 des Transducers 1 ein langgestrecktes Bondwerkzeug 2 festgelegt, welches auf einer dem Transducer 1 abgewandten Seite verjüngend ausgebildet ist und eine Werkzeugspitze 12 formt. Im Bereich der Werkzeugspitze 12 wird der Bonddraht positioniert und gegen das Substrat gedrückt. Zum Festlegen des Bondwerkzeugs 2 weist der Transducer 1 eine Werkzeugaufnahme 3 auf. An der Werkzeugaufnahme 3 ist das Bondwerkzeug 2 über eine Schraube 4 abnehmbar gehalten. Die Anregung des Piezoaktors 5 erfolgt über zwei auf gegenüberliegenden Seiten des Piezoaktors 5 vorgesehene Elektroden 20.

Als Teil des Transducers 1 ist weiter ein Befestigungsabschnitt 6 mit einer Bohrung 7 vorgesehen. Der Befestigungsabschnitt 6 dient zum Festlegen des Transducers 1 an dem Bondkopf der Bondvorrichtung. Insbesondere wird mittels geeigneter Verbindungsmittel der Transducer 1 im Bereich der Bohrung 7 des Befestigungsabschnitts 6 an dem Bondkopf gehalten. Zwischen dem Befestigungsabschnitt 6 einerseits und der Werkzeugaufnahme 3 andererseits ist ein Piezoaktor 5 vorgesehen. Der Piezoaktor 5 ist quaderförmig ausgebildet. Er weist auf zwei gegenüberliegenden Seiten ebene Anlageflächen auf. Mit den ebenen Anlageflächen liegt der Piezoaktor 5 an einer korrespondierend gestalteten Anschlussfläche des Befestigungsabschnitts 6 einerseits und einer korrespondierend gestalteten Anschlussfläche der Werkzeugaufnahme 3 andererseits an. Die Verbindung des Piezoaktors 5 mit der Werkzeugaufnahme 3 einerseits und dem Befestigungsabschnitt 6 andererseits wird insbesondere klebetechnisch hergestellt. Die gegenüberliegenden ebenen Anlageflächen des Piezoaktors 5 sind hierzu mit den korrespondierend gestalteten Anschlussflächen der Werkzeugaufnahme 3 beziehungsweise des Befestigungsabschnitts 6 flächig verklebt.

In einem montierten Zustand ist der Transducer 1 so an dem Bondkopf der Bondvorrichtung festgelegt, dass eine Längsrichtung 8 des Transducers 1 parallel zu einer Rotationsachse des Bondkopfs orientiert ist. Zugleich erstreckt sich eine Achse eines minimalen Massenträgheitsmoments 19 parallel zu der Längsrichtung 8 des Transducers 1. Insofern ist auch die Achse des minimalen Trägheitsmoments 19 parallel zu der Rotationsachse des Bondkopfs orientiert. Vorzugsweise ist ein quer zu der Längsrichtung 8 bestimmter Abstand zwischen der Achse des minimalen Massenträgheitsmoments 19 des Transducers 1 und der Rotationsachse des Bondkopfs gering. Besonders bevorzugt ist die Achse des minimalen Massenträgheitsmoments 19 koaxial zur Rotationsachse des Bondkopfs. Die entsprechende Positionierung des Transducers 1 an dem Bondkopf verbessert die Dynamik der Bondvorrichtung. Insbesondere kann der Bondkopf besonders schnell positioniert und um die Rotationsachse gedreht werden. Entsprechend können pro Zeiteinheit viele Bondverbindungen hergestellt werden und die Verwendung der Bondvorrichtung ist wirtschaftlich vorteilhaft.

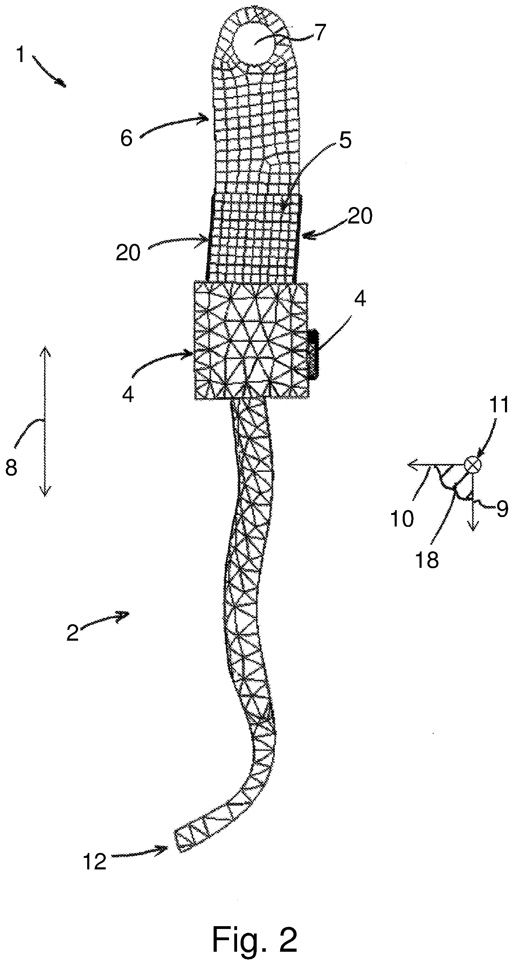

Die Fig. 2 zeigt den Piezoaktor 5, der eine Ultraschallschwingung des in die Längsrichtung 8 erstreckten Transducers 1 und des Bondwerkzeugs 2 in einer Scherebene 18 anregt. Der Piezoaktor 5 beziehungsweise ein geometrisches Zentrum desselben ist bevorzugt in einem Knoten der Ultraschallschwingung positioniert. Ebenso ist die Bohrung 7 des Befestigungsabschnitts 6 in einem Knoten der Ultraschallschwingung vorgesehen. Die Anbindung des Transducers 1 an dem Bondkopf erfolgt insofern im Bereich eines Schwingungsknotens. Ebenfalls ist das Bondwerkzeug 2 bevorzugt im Bereich eines Schwingungsknotens in der Werkzeugaufnahme 3 festgelegt, wobei die Anregung des Bondwerkzeugs 2 rotatorisch erfolgt. Ein Schwingungsbauch befindet sich an der Spitze 12 des Bondwerkzeugs 2. Die von dem Piezoaktor 5 angeregte und von dem Transducer 1 auf das Bondwerkzeug 2 übertragene Ultraschallschwingung verursacht so eine maximale Relativbewegung zwischen einem an der Spitze 12 des Bondwerkzeugs 2 gehaltenen und gegen ein Substrat gedrückten Bonddraht und dem Substrat.

Die Befestigung des Transducers 1 über die Bohrung 7 ist lediglich exemplarisch. Nach einer alternativen, nicht dargestellten Ausführungsform der Erfindung kann der Transducer 1 über ein Gewinde festgelegt, an einer Aufnahme einer Werkzeugmaschine angeklebt, geklemmt oder anderweitig befestigt sein. Ferner kann vorgesehen sein, dass die Befestigung außerhalb eines Schwingungsknotens erfolgt.

Nach einer alternativen, nicht dargestellten Ausführungsform der Erfindung kann das Bondwerkzeug 2 außerhalb eines Schwingungsknotens der Ultraschallschwingung an der Werkzeugaufnahme 3 festgelegt werden. Die Anregung des Bondwerkzeugs 2 erfolgt dann nicht rein rotatorisch, sondern durch eine überlagerte rotatorische und lineare Schwingung. Die lineare Schwingung ist insbesondere quer zur Längsrichtung 8 des Transducers 1 orientiert.

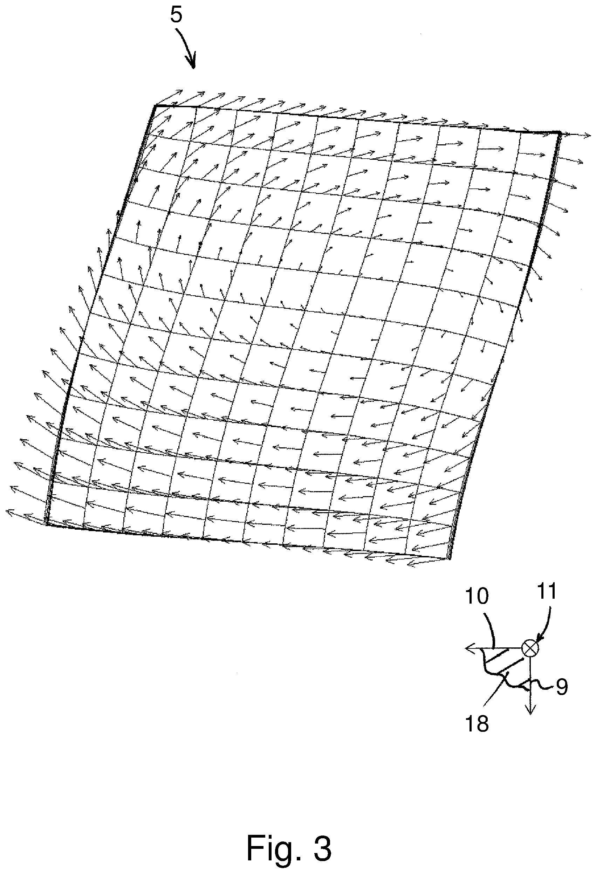

Zur Anregung der in Fig. 2 dargestellten Schwingungsform in dem Transducer 1 und dem Bondwerkzeug 2 führt der Piezoaktor 5 wie in Fig. 3 dargestellt eine Ultraschallschwingung in der Scherebene 18 aus. Der Piezoaktor 5 ist in eine Polarisationsrichtung 9 polarisiert. Ein elektrisches Feld liegt senkrecht zu der Polarisationsrichtung 9 in eine Feldrichtung 10 an dem Piezoaktor 5 an. Zur Bereitstellung des elektrischen Felds sind an dem Piezoaktor 5 die Elektroden 20 vorgesehen. Infolge der Polarisation in die Polarisationsrichtung 9 und des anliegenden elektrischen Felds quer hierzu wird in der durch die Polarisationsrichtung 9 und die Feldrichtung 10 definierten Scherebene 18 eine Ultraschallschwingung ausgeführt.

Gemäß der Erfindung führt dies dazu, dass resultierend der Transducer 1 die Ultraschallschwingung als Eigenschwingung beziehungsweise Biegeschwingung ausführt. Beispielsweise erfolgt die Ultraschallschwingung um eine zu der Scherebene 18 senkrecht orientierte Drehachse 11 (entspricht der 2-Richtung). Die Scherbewegung des Piezoaktors 5 in der Scherebene 18 bildet in dem Transducer 1 und dem Bondwerkzeug 2 die Ultraschalleigenschwingung aus. Vorliegend erstreckt sich die Längsrichtung 8 in der Scherebene 18 beziehungsweise die Polarisationsrichtung 9 ist in die Längsrichtung 8 erstreckt.

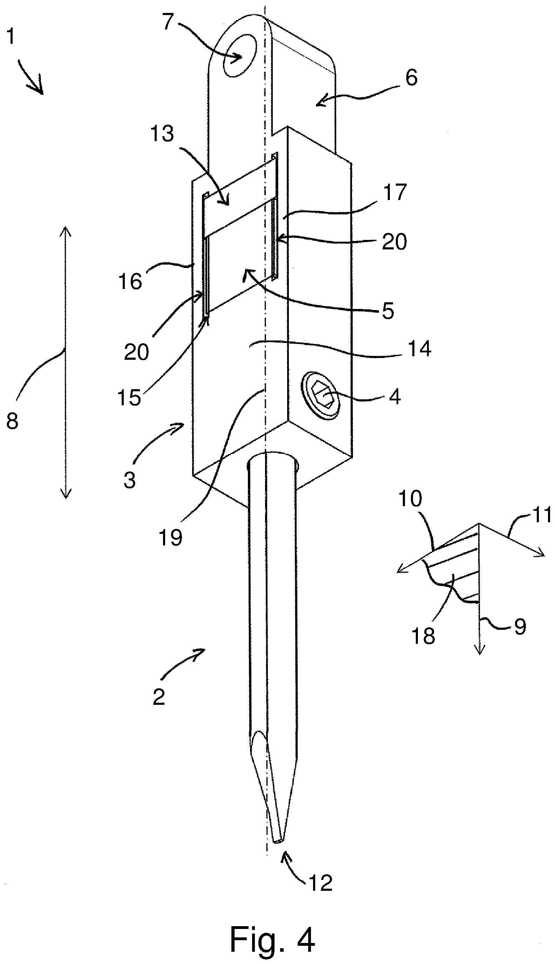

Eine alternative Ausführungsform des erfindungsgemäßen Transducers 1 nach Fig. 4 sieht einen den Befestigungsabschnitt 6 und die Werkzeugaufnahme 3 aufweisenden Transducerkörper 14 vor. An dem einstückig ausgeführten Transducerkörper 14 ist eine Ausnehmung 15 vorgesehen, welche nach Art eines in Richtung der Drehachse 11 erstreckten Durchbruchs ausgebildet ist. In der Ausnehmung 15 ist einerseits der Piezoaktor 5 positioniert. Darüber hinaus ist ein Klemmmodul 13 in der Ausnehmung 15 vorgesehen, welches dazu dient, den Piezoaktor 5 kraftschlüssig mit dem Transducerkörper 14 zu verbinden. Das Klemmmodul 13 verfügt hierzu über nicht einzeln dargestellte Klemmkeile, welche relativbeweglich zueinander gehalten sind und so festgelegt werden, dass der Piezoaktor 5 kraftschlüssig in der Ausnehmung 15 gehalten ist. Eine von dem Piezoaktor 5 ausgeführte Scherbewegung regt insofern in bekannter Weise die zur Herstellung der Bondverbindung zwischen dem Bonddraht und dem Substrat genutzte Ultraschallschwingung in dem Transducer 1 und dem Bondwerkzeug 2 an.

An dem Transducerkörper 14 sind im Bereich der Ausnehmung 15 ein erster Schenkel 16 und ein zweiter Schenkel 17 vorgesehen. Der erste Schenkel 16 und der zweite Schenkel 17 verbinden den Befestigungsabschnitt 6 und die Werkzeugaufnahme 3 miteinander. Sie sind in die Längsrichtung 8 des Transducers 1 erstreckt und vergleichsweise nachgiebig ausgeführt. Insbesondere sind die Schenkel 16, 17 beabstandet zu dem Piezoaktor 5 auf gegenüberliegenden Seiten desselben vorgesehen. Die einander gegenüberliegenden Anlageflächen des Piezoaktors 5 liegen an der Werkzeugaufnahme 3 einerseits und einer korrespondierend gestalteten Anschlussfläche des Klemmmoduls 13 andererseits an. Das Klemmmodul 13 ist insofern zwischen dem Piezoaktor 5 und dem Befestigungsabschnitt 6 des Transducers 1 vorgesehen.

Nach einer alternativen, nicht dargestellten Ausführungsform der Erfindung kann das Klemmmodul 13 zwischen dem Piezoaktor 5 und der Werkzeugaufnahme 3 des Transducers 1 vorgesehen sein. Auf die Ausnehmung 15 kann verzichtet sein, die Schenkel 16, 17 können unmittelbar an den Piezoaktor 5 beziehungsweise die Elektroden 20 angelegt und gegen diese isoliert sein.

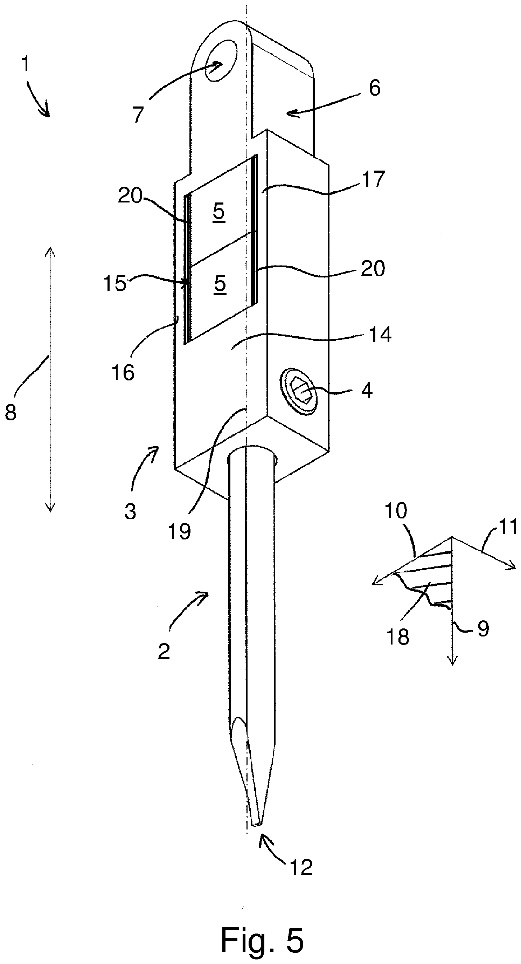

Nach einer alternativen Ausführungsform der Erfindung gemäß Fig. 5 weist der Transducer 1 zwei in der Ausnehmung 15 vorgesehene Piezoaktoren 5 auf. Die Piezoaktoren 5 sind so ausgebildet, dass sie in der Scherebene 18 eine Scherbewegung als Ultraschallschwingung ausbilden. Gemeinsam regen sie die Ultraschalleigenschwingung des Transducers 1 und des Bondwerkzeugs 2 an.

Die Piezoaktoren 5 sind insbesondere kraftschlüssig in der Ausnehmung 15 gehalten. Beispielsweise wird zur kraftschlüssigen Aufnahme der Piezoaktoren 5 in der Ausnehmung 15 der unterschiedliche thermische Ausdehnungskoeffizient der zur Herstellung der Piezoaktoren 5 verwendeten Piezokeramik einerseits und des bevorzugt aus einem metallischen Werkstoff hergestellten Transducerkörpers 14 andererseits verwendet.

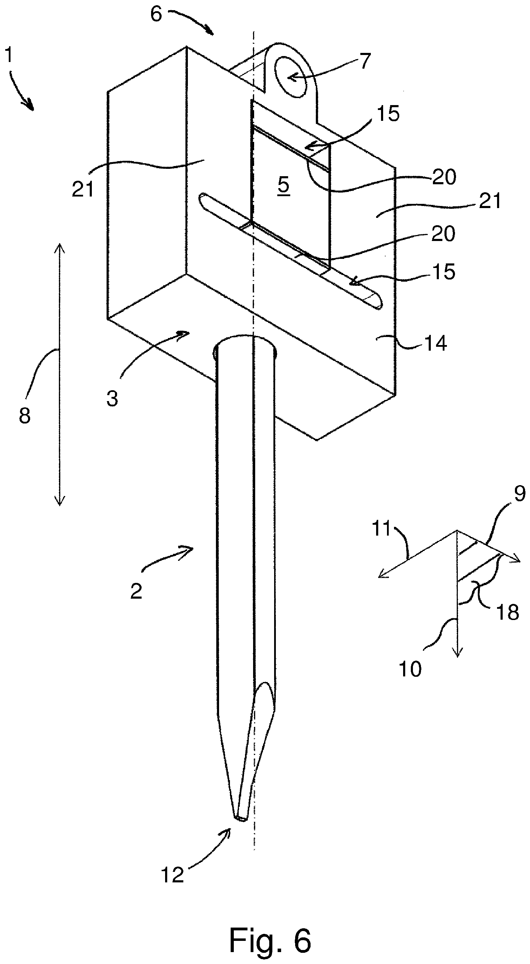

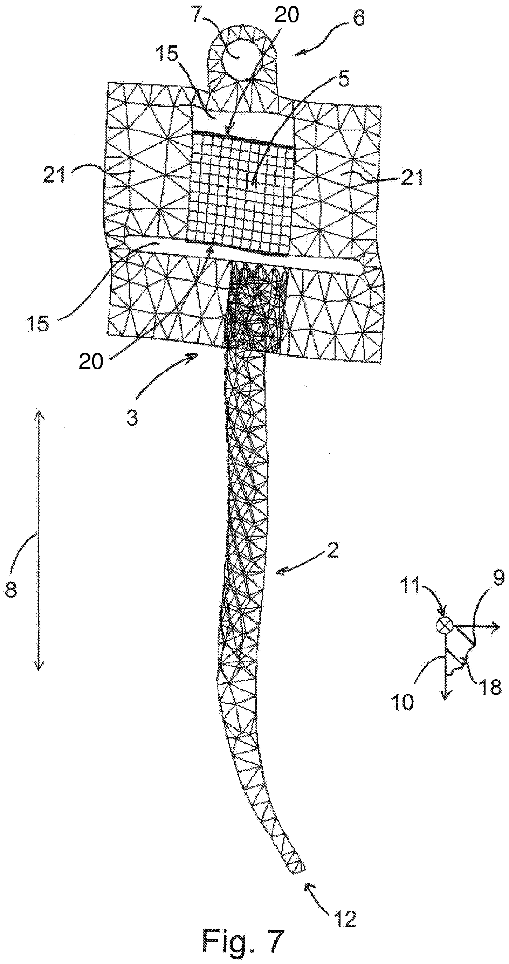

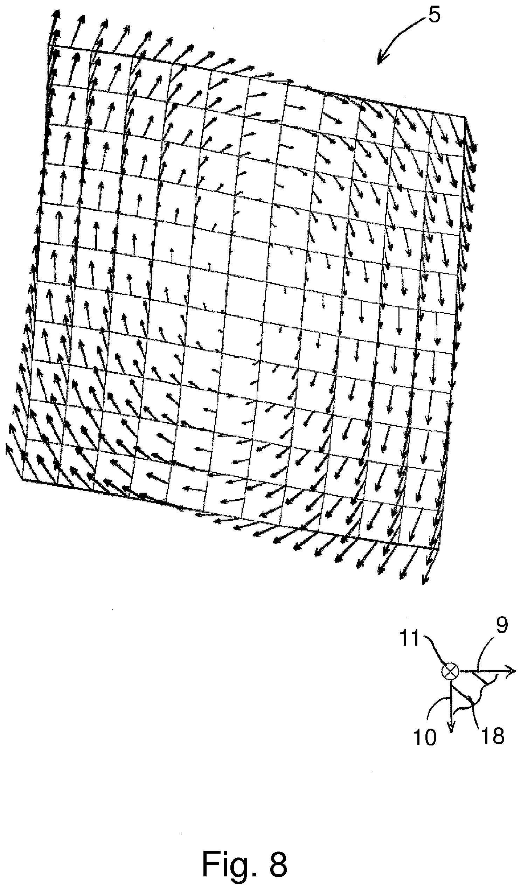

Eine vierte Ausführungsform des erfindungsgemäßen Transducers 1 ist in den Fig. 6 bis 8 gezeigt. Der Transducer 1 besitzt einen Transducerkörper 14, in dem der Piezoaktor 5 festgelegt ist. Die Polarisationsrichtung 9 ist senkrecht zu der Längsrichtung 8 des Transducers 1 erstreckt. Das elektrische Feld ist in die Längsrichtung 8 angelegt, das heißt, die Feldrichtung 10 ist parallel zur Längsrichtung 8.

Die Festlegung des Piezoaktors 5 am Transducerkörper 14 erfolgt über zwei seitliche Wangen 21 des Transducerkörpers 14. Beispielsweise ist der Piezoaktor 5 zwischen den Wangen 21 geklemmt. Beispielsweise ist der Piezoaktor 5 verklebt mit den Wangen 21 vorgesehen. Die einander gegenüberliegenden Elektroden 20 sind benachbart zu zwei Ausnehmungen 15 vorgesehen, welche die Ausprägung einer Scherschwingung des Piezoaktors 5 in der von der Polarisationsrichtung 9 und der Feldrichtung 10 aufgespannten Scherebene 18 begünstigen.

Zur Festlegung des Werkzeugs 2 an dem Transducerkörper 14 wird vorliegend exemplarisch auf eine Schraube 4 verzichtet. Beispielsweise erfolgt die Festlegung des Werkzeugs 2 an der Werkzeugaufnahme 3 des Transducerkörpers 14 mittels Klemmung.

Zur Verdeutlichung der Erfindung ist die Darstellung des Transducers 1 bei den dargestellten Ausführungsformen auf die erfindungswesentlichen Aspekte und Merkmale beschränkt. Weitere Komponenten können an dem Transducer 1 vorgesehen werden. Der Piezoaktor 5 ist prinziphaft dargestellt. Es kann beispielsweise ein aus einer einzigen Piezokeramik hergestellter Piezoaktor 5 vorgesehen sein. Beispielsweise kann der Piezoaktor 5 eine Mehrzahl scheibenförmiger Piezokeramiken aufweisen. Beispielsweise kann der Piezoaktor 5 nach Art eines Piezostapelaktors ausgebildet sein.

Gleiche Bauteile und Bauteilfunktionen sind durch gleiche Bezugszeichen gekennzeichnet.

## Patentansprüche

1. Vorrichtung zum Herstellen einer Bondverbindung umfassend einen um eine Rotationsachse drehbar gehaltenen Bondkopf und einen Transducer (1), welcher an dem Bondkopf gehalten ist, wobei der Transducer (1) einen Piezoaktor (5) zum Anregen einer Ultraschalleigenschwingung, einen Befestigungsabschnitt (6) zum Festlegen des Transducers (1) an dem Bondkopf und eine Werkzeugaufnahme (3) für ein Bondwerkzeug (2) aufweist, wobei eine Längsrichtung (8) des Transducers (1) und/oder eine Erstreckungsrichtung desselben in Richtung einer Achse eines minimalen Massenträgheitsmoments (19) parallel zu der Rotationsachse des Bondkopfs erstreckt ist, **dadurch gekennzeichnet, dass** an dem Piezoaktor (5) Elektroden (20) derart vorgesehen sind, dass der Piezoaktor (5) quer zu einer Polarisationsrichtung (9) desselben in eine Feldrichtung (10) mittels eines elektrischen Felds anregbar ist und dass der Piezoaktor (5) infolge der Anregung und einer Anbindung desselben an den Befestigungsabschnitt (6) und an die Werkzeugaufnahme (3) eine Scherbewegung in einer durch die Polarisationsrichtung (9) und die Feldrichtung (10) gebildeten Scherebene (18) ausführt.

2. Vorrichtung nach Anspruch 1, **dadurch gekennzeichnet, dass** der Piezoaktor (5) formschlüssig und/oder kraftschlüssig und/oder stoffschlüssig verbunden ist mit der Werkzeugaufnahme (3) und/oder dem Befestigungsabschnitt (6).

3. Vorrichtung nach Anspruch 1 oder 2, **dadurch gekennzeichnet, dass** der Piezoaktor (5) gegen die Werkzeugaufnahme (3) und/oder den Befestigungsabschnitt (6) verklemmt ist.

4. Vorrichtung nach einem der Ansprüche 1 bis 3, **dadurch gekennzeichnet, dass** zur Klemmung des Piezoaktors (5) ein Klemmmodul (13) vorgesehen ist, welches mechanisch verstellbar ist.

5. Vorrichtung nach einem der Ansprüche 1 bis 4, **dadurch gekennzeichnet, dass** der Piezoaktor (5) quaderförmig ausgebildet ist und/oder auf zwei gegenüberliegenden Seiten eine ebene Anlagefläche aufweist zum Anlegen des Piezoaktors (5) an eine korrespondierend gestaltete Anschlussfläche der Werkzeugaufnahme (3) und/oder des Klemmmoduls (13) und/oder des Befestigungsabschnitts (6).

6. Vorrichtung nach einem der Ansprüche 1 bis 5, **dadurch gekennzeichnet, dass** der Piezoaktor (5) mit der Werkzeugaufnahme (3) und/oder dem Befestigungsabschnitt (6) verklebt ist.

7. Vorrichtung nach einem der Ansprüche 1 bis 6, **dadurch gekennzeichnet, dass** ein Transducerkörper (14) vorgesehen ist mit einer Ausnehmung (15), wobei der Piezoaktor (5) in der Ausnehmung (15) des Transducerkörpers (14) vorgesehen ist.

8. Vorrichtung nach einem der Ansprüche 1 bis 7, **dadurch gekennzeichnet, dass** die Ausnehmung (15) nach Art einer in Richtung der Drehachse (11) erstreckten Durchbruchausnehmung (15) ausgebildet ist.

9. Vorrichtung nach einem der Ansprüche 1 bis 8, **dadurch gekennzeichnet, dass** die Werkzeugaufnahme (3) und/oder der Befestigungsabschnitt (6) als Teil des Transducerkörpers (14) realisiert sind und/oder dass der Piezoaktor (5) zwischen der Werkzeugaufnahme (3) und dem Befestigungsabschnitt (6) vorgesehen ist.

10. Vorrichtung nach einem der Ansprüche 1 bis 9, **dadurch gekennzeichnet, dass** der Piezoaktor (5) im Knoten der ausgeführten Ultraschalleigenschwingung vorgesehen ist und/oder dass eine Ultraschallbiegeeigenschwingung in dem Transducer (1) angeregt ist.

11. Vorrichtung nach einem der Ansprüche 1 bis 10, **dadurch gekennzeichnet, dass** eine Bohrung der Werkzeugaufnahme (3) in einem Knoten der ausgeführten Ultraschalleigenschwingung vorgesehen ist und/oder dass das Werkzeug im Knoten an der Werkzeugaufnahme (3) festgelegt ist.

12. Vorrichtung nach einem der Ansprüche 1 bis 11, **dadurch gekennzeichnet, dass** die Rotationsachse des Bondkopfs koaxial zu der Achse des minimalen Massenträgheitsmoments (19) des Transducers (1) vorgesehen ist.

13. Vorrichtung nach einem der Ansprüche 1 bis 12, **dadurch gekennzeichnet, dass** der Piezoaktor (5) verwindungssteif mit dem Befestigungsabschnitt (6) und/oder der Werkzeugaufnahme (3) verbunden ist.

14. Verwendung einer Bondvorrichtung nach einem der Ansprüche 1 bis 13 zum Ultraschall-Drahtbonden.

## Claims

1. Device for establishing a bonded connection comprising a bonding head held rotatably around a rotational axis and a transducer (1) held on the bonding head, wherein the transducer (1) exhibits a ceramic actuator (5) for exciting an ultrasonic natural vibration, a fixing portion (6) for fixing the transducer (1) to the bonding head, and a tool holder (3) for a bonding tool (2), wherein a longitudinal direction (8) of the transducer (1) and/or a direction of elongation of the same towards an axis of a minimum moment of inertia (19) is aligned parallel to the rotational axis of the bonding head, **characterised in that** electrodes (20) are provided on the ceramic actuator (5) such that the ceramic actuator (5) is excitable by means of an electrical field in a field direction (10) transversely to a polarisation direction (9) of said ceramic actuator (5) and **in that** as a result of the excitation and a connection of the ceramic actuator (5) to the fixing portion (6) and to the tool holder (3) said ceramic actuator (5) executes a shearing motion on a shearing plane (18) formed by means of the polarisation direction (9) and the field direction (10).

2. Device according to claim 1, **characterised in that** the ceramic actuator (5) is joined to the tool holder (3) and/or the fixing portion (6) in a form-fit and/or interference-fit and/or bonded connection.

3. Device according to claim 1 or claim 2, **characterised in that** the ceramic actuator (5) is clamped against the tool holder (3) and/or the fixing portion (6).

4. Device according to any one of claims 1 to 3, **characterised in that** for clamping the ceramic actuator (5) a clamping module (13) is provided, which is mechanically adjustable.

5. Device according to any one of claims 1 to 4, **characterised in that** the ceramic actuator (5) is cuboidal in design and/or has a flat contact surface on two opposing faces for positioning the ceramic actuator (5) on a correspondingly designed connecting surface of the tool holder (3) and/or of the clamping module (13) and/or of the fixing portion (6).

6. Device according to any one of claims 1 to 5, **characterised in that** the ceramic actuator (5) is bonded to the tool holder (3) and/or the fixing portion (6).

7. Device according to any one of claims 1 to 6, **characterised in that** a transducer body (14) is constructed with a recess (15), with the ceramic actuator (5) provided in the recess (15) of said transducer body (14).

8. Device according to any one of claims 1 to 7, **characterised in that** the recess (15) is provided in the manner of a through-recess (15) extending in the direction of the axis of rotation (11).

9. Device according to any one of claims 1 to 8, **characterised in that** the tool holder (3) and/or the fixing portion (6) are realised as part of the transducer body (14) and/or **in that** the ceramic actuator (5) is provided between the tool holder (3) and the fixing portion (6).

10. Device according to any one of claims 1 to 9, **characterised in that** the ceramic actuator (5) is provided in the node of the executed ultrasonic natural vibration and/or in that an ultrasonic natural bending vibration is excited in the transducer (1).

11. Device according to any one of claims 1 to 10, **characterised in that** a bore of the tool holder (3) is provided in a node of the executed ultrasonic natural vibration and/or **in that** the tool is fixed in the node on the tool holder (3).

12. Device according to any one of claims 1 to 11, **characterised in that** the rotational axis of the bonding head is provided coaxially to the axis of the minimum moment of inertia (19) of the transducer (1).

13. Device according to any one of claims 1 to 12, **characterised in that** the ceramic actuator (5) is connected to the fixing portion (6) and/or tool holder (3) in a torsion-resistant manner.

14. Use of a bonding device according to any one of claims 1 to 13 for ultrasonic wire bonding.

## Revendications

1. Dispositif de fabrication d'un moyen de liaison, comprenant une tête de liaison maintenue rotative autour d'un axe de rotation et un transducteur (1) qui est maintenu sur la tête de liaison, dans lequel le transducteur (1) présente un actionneur piézoélectrique (5) destiné à exciter une auto-oscillation par ultrasons, une section de fixation (6) destinée à fixer le transducteur (1) sur la tête de liaison et une réception d'outil (3) pour un outil de liaison (2), dans lequel une direction longitudinale (8) du transducteur (1) et/ou une direction d'extension de celui-ci s'étend en direction d'un axe d'un moment d'inertie massique minimal (19) parallèle à l'axe de rotation de la tête de liaison, **caractérisé en ce que**, sur l'actionneur piézoélectrique (5), des électrodes (20) sont prévues de telle sorte que l'actionneur piézoélectrique (5) est excitable transversalement à une direction de polarisation (9) de celui-ci dans une direction de champ (10) au moyen d'un champ électrique et que l'actionneur piézoélectrique (5) exécute, suite à l'excitation et à une liaison de celui-ci sur la section de fixation (6) et sur la réception d'outil (3), un mouvement de cisaillement dans un plan de cisaillement (18) formé par la direction de polarisation (9) et la direction de champ (10).

2. Dispositif selon la revendication 1, **caractérisé en ce que** l'actionneur piézoélectrique (5) est relié à la réception d'outil (3) et/ou à la section de fixation (6) par complémentarité de forme et/ou par complémentarité de force et/ou par complémentarité de matière.

3. Dispositif selon la revendication 1 ou 2, **caractérisé en ce que** l'actionneur piézoélectrique (5) est coincé contre la réception d'outil (3) et/ou la section de fixation (6).

4. Dispositif selon une des revendications 1 à 3, **caractérisé en ce que**, pour coincer l'actionneur piézoélectrique (5), un module de serrage (13) qui est réglable mécaniquement est prévu.

5. Dispositif selon une des revendications 1 à 4, **caractérisé en ce que** l'actionneur piézoélectrique (5) a une configuration parallélépipédique et/ou présente sur deux faces opposées une surface d'appui plane pour appuyer l'actionneur piézoélectrique (5) contre une surface de jonction de la réception d'outil (3) et/ou du module de serrage (13) et/ou de la section de fixation (6) qui est configurée de manière correspondante.

6. Dispositif selon une des revendications 1 à 5, **caractérisé en ce que** l'actionneur piézoélectrique (5) est collé avec la réception d'outil (3) et/ou la section de fixation (6).

7. Dispositif selon une des revendications 1 à 6, **caractérisé en ce qu'**un corps de transducteur (14) est prévu avec un évidement (15), l'actionneur piézoélectrique (5) étant prévu dans l'évidement (15) du corps de transducteur (14).

8. Dispositif selon une des revendications 1 à 7, **caractérisé en ce que** l'évidement (15) est configuré sous la forme d'un évidement de passage (15) qui s'étend en direction de l'axe de rotation (11).

9. Dispositif selon une des revendications 1 à 8, **caractérisé en ce que** la réception d'outil (3) et/ou la section de fixation (6) sont réalisées en tant que partie du corps de transducteur (14) et/ou **en ce que** l'actionneur piézoélectrique (5) est prévu entre la réception d'outil (3) et la section de fixation (6).

10. Dispositif selon une des revendications 1 à 9, **caractérisé en ce que** l'actionneur piézoélectrique (5) est prévu dans le noeud de l'auto-oscillation par ultrasons exécutée et/ou **en ce qu'**une auto-oscillation courbée par ultrasons est excitée dans le transducteur (1).

11. Dispositif selon une des revendications 1 à 10, **caractérisé en ce qu'**un perçage de la réception d'outil (3) est prévu dans un noeud de l'auto-oscillation par ultrasons exécutée et/ou **en ce que** l'outil est fixé dans le noeud sur la réception d'outil (3).

12. Dispositif selon une des revendications 1 à 11, **caractérisé en ce que** l'axe de rotation de la tête de liaison est prévu coaxialement à la l'axe du moment d'inertie massique minimal (19) du transducteur (1).

13. Dispositif selon une des revendications 1 à 12, **caractérisé en ce que** l'actionneur piézoélectrique (S) est relié à la section de fixation (6) et/ou à la réception d'outil (3) de manière rigide en torsion.

14. Utilisation d'un dispositif de liaison selon une des revendications 1 à 13 pour des liaisons de fil par ultrasons.
